# EUROPEAN PATENT APPLICATION

(11) **EP 4 844 432 A1**
(43) Date of publication of application: **25.11.2026**
(21) Application number: 25178152.2
(22) Date of filing: 22.05.2025
(51) Int. Cl.: G01R 33/56, G01R 33/561, G01R 33/50

(54) **RECONSTRUCTING IMAGE DATA FROM MULTI-CONTRAST MAGNETIC RESONANCE K-SPACE DATA**

(71) Applicant: Siemens Healthineers AG, 91301 Forchheim (DE)
(72) Inventor: Nickel, Marcel Dominik, 91074 Herzogenaurach (DE); Littmann, Arne, 91052 Erlangen (DE); Meixner, Christian, 91054 Erlangen (DE); Yoon, Seung Su, 91052 Erlangen (DE); Zeller, Mario, 91054 Erlangen (DE)
(74) Representative: Siemens Healthineers Patent Attorneys

(57) **Abstract**

The invention relates to a computer-implemented method for reconstructing image data from multi-contrast magnetic resonance k-space data using a trained machine learning model, the method comprising:
(a) receiving acquired multi-contrast k-space data acquired with multiple contrasts;
(b) in order to generate image data, performing an iterative machine-learning-based k-space-to-image reconstruction on the acquired multi-contrast k-space data comprising iterating between reconstruction steps of

- applying an extended conventional image reconstruction involving a parallel imaging model, the parallel imaging model relating image data to k-space data independently for each contrast, wherein the conventional image reconstruction is extended by an added regularization that connects the multiple contrasts,
and
- applying the trained machine learning model to enhance image data.

## Description

The invention relates to a computer-implemented method for reconstructing image data from multi-contrast magnetic resonance k-space data, a method for generating magnetic resonance image data, a corresponding computer program or computer-readable storage medium, and a corresponding magnetic resonance imaging system.

Independent of the grammatical term usage, individuals with male, female or other gender identities are included within the term.

Magnetic Resonance (MR) Imaging (MRI) plays an important role in clinical diagnosis. In order to accelerate acquisition, under-sampling of k-space data during image acquisition has been applied in multiple variants. For this purpose, advanced imaging techniques have been introduced to enable the acceleration of image acquisition while maintaining a sufficiently high diagnostic confidence. In particular, parallel imaging and Compressed Sensing are methods that are used for this purpose. In parallel imaging, multiple receiver coils as well as knowledge about their positioning and sensitivities are used to assist a spatial localization of the acquired magnetic resonance signal (MR signal) in order to be able to reduce the number of phase encoding steps during image acquisition. Known parallel imaging techniques are, for example, GRAPPA ("GeneRalized Autocalibrating Partial Parallel Acquisition"), CAIPIRINHA (Controlled Aliasing in Parallel Imaging Results in Higher Acceleration) or SENSE ("SENStivity Encoding"). Compressed Sensing modifies the image acquisition by using incoherent acquisitions with irregular sampling pattern combined with a non-linear image reconstruction. Using incoherent acquisitions with irregular sampling pattern allows to even further accelerate image acquisition times compared to the uniform sampling used for parallel imaging. However, in Compressed Sensing the obtained images tend to look more artificial.

A more recent approach is to apply an image reconstruction based on deep learning. Deep learning-based image reconstruction allows to significantly accelerate acquisitions by under-sampling while keeping image impression and contrast. Typically, the reconstruction performs an image enhancement and/or denoising during the formation of the images from k-space data by interleaving the physics-based reconstruction with trainable components. One recent approach of a deep learning-based image reconstruction is described in "Prospective Deployment of Deep Learning Reconstruction Facilitates Highly Accelerated Upper Abdominal MRI", Brendel, Jan M. et al., Academic Radiology, Volume 31, Issue 12, 4965 - 4973. In this publication, the deep learning-based image reconstruction is implemented in a two-step approach using six iterations that alternate between a conventional parallel imaging reconstruction and image enhancement employing a deep learning model based on a neural network, namely on three-dimensional U-nets. In particular, the conventional parallel imaging reconstruction receives k-space data, a parallel imaging model (in form of coil sensitivity maps) and a prior image estimate to calculate a new image and where the output is evaluated through a neural network. This may be expressed as ${x}_{n + 1 / 2} = {argmin}_{x} \left({\left‖Ax-y\right‖}^{2}+\frac{1}{{λ}_{n}^{2}}{\left‖x-{x}_{n}\right‖}^{2}\right) ,$ [1] ${x}_{n + 1} = {U}_{n} \left({x}_{n + 1 / 2}\right) .$ [2] where *x*_{*n+*1/2} is the reconstructed image of the parallel imaging step, *A* is a system operator (parallel imaging model) that connects k-space data and a reconstructed image, y are the acquired k-space data, *λₙ* is a regularization parameter, that may also be referred to as step-size and *xₙ* can be considered as a prior image estimate. The system operator *A* may comprise coil sensitivities of the MR system. Equation [1] without the regularization term corresponds to a standard SENSE parallel imaging reconstruction. The regularization term ensures that the problem is not under-constrained. *Uₙ* denotes a neural network for image enhancement or to estimate the next prior image. The term of equation [1] generates an image *x*_{*n+*1/2} from the prior image and *Uₙ* (equation [2]) generates the next prior image *x*_{*n*+1} from the output of equation 1, which in turn is feed back into equation [1]. *Uₙ* may in particular be a network for image denoising and may be trained in a supervised manner, e.g., by retrospective under-sampling of fully sampled datasets.

Deep learning-based reconstruction has made a huge impact on MRI and has been introduced for most conventional acquisition types. However, for applications with multiple contrasts, the approach of supervised learning has limitations, for example, due to a lack of training data for more challenging acquisition types. Since, typically, generating training data involves in-vivo measurements, providing sufficient amounts of ground truth data has turned out to be difficult.

There are multiple applications in MRI with multiple contrasts. For example, multiple contrasts may be applied to generate time-resolved imaging and/or for quantitative imaging. For example, time-resolved imaging may connect neighbouring time-points. Time resolved-data may, for example, be acquired by using contrast agent and observing an increasing and/or decreasing contrast, e.g. when the contrast agent arrives at its destination (e.g. a tumour) and/or is reduced again over time. Examples for time-resolved imaging with multiple contrasts are DCE (Dynamic Contrast Enhanced), angiography, or CINE, i.e. a movie mode for displaying dynamic processes such as cardiac movement. For example, quantitative parameters may be calculated by parametric mapping using multiple contrasts, such as contrasts sampled along a relaxation curve (e.g. Look-Locker T1 mapping, T2 mapping). In Lugauer, F., Wetzl, J., Forman, C. et al. Single-breath-hold abdominal mapping using 3D Cartesian Look-Locker with spatiotemporal sparsity constraints. Magn Reson Mater Phy 31, 399-414 (2018) (https://doi.org/10.1007/s10334-017-0670-8), an example of T1-mapping, in partiuclar breathheld volumetric T1-mapping, is described. Further example for applications with multiple contrasts are VFA T1 mapping (Variable Flip Angle T1 mapping) and the Dixon method for separating water and fat tissue.

It is therefore an object of the invention to provide a method that enables using a machine-learning-based reconstruction while preferably finding a solution for the difficulty of providing sufficient training data for applications with multiple contrasts.

This object is met or exceeded by a method according to claim 1, a method according to claim 12, a computer program or computer-readable storage medium according to claim 13, a processing unit according to claim 14 and a magnetic resonance imaging system according to claim 15. Further advantages and features result from the dependent claims, the description and the attached figures.

In the following, the solution according to the invention is described with respect to the claimed methods as well as with respect to the claimed system, processing unit, computer program and storage medium. Features, advantages or alternative embodiments herein can be assigned to the other claimed objects and vice versa. In other words, claims and embodiments for the methods can be improved with features described or claimed in the context of the system, computer program or storage medium. The functional features of the method may be implemented by physical units of the system.

According to a first aspect of the invention, a computer-implemented method for reconstructing image data from multi-contrast magnetic resonance k-space data using a trained machine learning model, in particular a trained deep-learning model, is provided. The method comprises the following steps:
(a) receiving acquired multi-contrast k-space data acquired with multiple contrasts;
(b) in order to generate image data, performing an iterative machine-learning-based k-space-to-image reconstruction on the acquired multi-contrast k-space data comprising iterating between reconstruction steps of
   - applying an extended conventional image reconstruction involving a parallel imaging model, the parallel imaging model relating image data to k-space data independently for each contrast, wherein the conventional image reconstruction is extended by an added regularization that connects the multiple contrasts,
      and
   - applying the trained machine learning model to enhance image data.

Advantageously, with the method according to the invention, the benefits of applying a trained machine learning model, such as enabling a better and more natural image quality, can be achieved. At the same time, due to the regularization, also multipe contrasts can be included and taken into account efficiently. It has been found, that this effect may even be achieved without having to specifically train the machine learning model for multiple contrasts. For example, a trained machine learning model that is trained without contrast dimension may be applied for each contrast separately, i.e. treating each contrast as single contrast data. This is supported by the the parallel imaging model relating image data to k-space data independently for each contrast. Hence training the machine learning model can be easier or even unnecessary in case of an already existing trained model.

K-space data acquired with multiple contrast may be MR k-space data of essentially the same object or area, in particular acquired during the same examination, that distinguishes different tissue-specific properties differently due to differences in their acquisition. Differences in the acquisition may comprise different contrast agent concentrations, different sequence types (e.g., T1 or T2 weighted) or different sequence parameters such as echo times or repetition times. "Contrast" generally may mean the difference in signal intensity between different tissues, and more specifically a "contrast" describes a general appearance of the different tissues in an MR-image. Different contrasts may arise because of tissue-specific properties or different concentrations of contrast agent being made visible by a suitable MR imaging technique, such that tissues with different tissue-specific properties or different concentrations of contrast agent appear with distinguishable data signals corresponding to different contrasts. Tissue-specific properties may in particular be inherent to the respective tissue or may depend on the enhancement of contrast agent in the respective tissue. Typical tissue-specific properties are proton density as well as T1 and T2 relaxation time. Data signals may be distinguishable due to different signal strengths or different levels of brightness, such as via different grey values. Optionally, the application of a suitable MR imaging technique may comprise the application of a contrast agent.

The multi-contrast k-space data may be acquired by means of a special MR imaging technique, which for example acquires k-space data at different echo times. Alternatively or additionally, the multi-contrast k-space data may be acquired by acquiring a time series of k-space datasets for which the concentration of contrast agent varies within the tissue, for example due to the inflow and/or outflow of contrast agent.

The acquired multi-contrast k-space data can also be denoted as acquired multi-contrast magnetic resonance imaging k-space data. Hence, the k-space data is data that has been acquired by a magnetic resonance imaging system. The acquired multi-contrast k-space data comprises multiple contrasts. Examples of applications in MRI with multiple contrasts are given in the introductory part above and it has been found that the invention can work particularly well with these examples. However, the invention may also be applied for other examples of multi-contrast magnetic resonance imaging.

After receiving the acquired multi-contrast k-space data, an iterative machine-learning-based k-space-to-image reconstruction is performed. Therein, it is iterated between applying the extended conventional image reconstruction and applying the trained machine learning model. The iteration may be generally based on the iteration as described above with equations [1] and [2], modified by adding the regularization. Considering multiple contrasts ${x}_{n}^{\left(c\right)}$*,* Equations [1] and [2] may be modified to be of the form ${x}_{n + 1 / 2}^{\left(c\right)} = {argmin}_{{x}^{\left(c\right)}} \left({\left‖{Ax}^{\left(c\right)}-{y}^{\left(c\right)}\right‖}^{2}+\frac{1}{{λ}_{n}^{2}}{\left‖{x}^{\left(c\right)}-{x}_{n}^{\left(c\right)}\right‖}^{2}\right) ,$ [3] ${x}_{n + 1}^{\left(c\right)} = {U}_{n} \left({x}_{n + 1 / 2}^{\left(c\right)}\right) ,$ [4] with *c* indexing *N_{c}* contrasts and *n* indexing *N* iterations, ${x}_{n + 1 / 2}^{\left(c\right)}$ being the reconstructed image of the parallel imaging step for each contrast *c*, *A* being a system operator (parallel imaging model) that connects k-space data and a reconstructed image, *y*^{(*c*)} being the acquired k-space data for each contrast, *λₙ* being a regularization parameter, that may also be referred to as step-size, ${x}_{n}^{\left(c\right)}$ being a prior image estimate (e.g., of a previous iteration step or according to an initialized image estimate), and *Uₙ*(. ) denoting the trained machine learning model, in particular a trained neural network. Notably, the reconstruction in equation [3] separates between the contrasts, so that they can be calculated independently. In the context of this invention, additionally, a regularization is added that connects the multiple contrasts. For this purpose, equation [3] may have the form $\left\{{x}_{n + 1 / 2}^{\left(c\right)}\right\} = {argmin}_{{x}^{\left(c\right)}} \left({\sum }_{c} \left({\left‖{Ax}^{\left(c\right)}-{y}^{\left(c\right)}\right‖}^{2}+\frac{1}{{λ}_{n}^{2}}{\left‖{x}^{\left(c\right)}-{x}_{n}^{\left(c\right)}\right‖}^{2}\right) + {α}_{n} R \left(\left\{{x}^{\left(c\right)}\right\}\right)\right) ,$ [5] where *αₙ* is a regularization strength and *R*({*x*^{(*c*)}}) is the added regularization, i.e., a regularization function, that connects the multiple contrasts. In particular, the complete set of images ({*x*^{(*c*)}}) are in the argument of the regularization function so that it can couple the different contrasts. Generally, the regularization strength may optionally be dependent on the current iteration step, i.e., in the example according to equation [5], dependent on *n*. A different regularization strength may be used for each iteration step (the different iteration steps being denoted by *n* in above example). For example, the regularization strength may be greater at earlier iterations and smaller, optionally even zero, at later iterations. Optionally, the regularization strength may be constant for all iteration steps. For example, in equation [5], *αₙ* may be replaced by *α,* if the regularization strength, is constant for all iteration steps. The regularization strength is greater than zero for at least one of the iteration steps. Preferably, the regularization strength is greater than zero at the first iteration step. Optionally the regularization strength may be a Lagrange multiplier. It should be noted that the equations given here and in the following are exemplary. While using such equations has been found to work particularly well in the context of this invention, the skilled person may implement the invention also by using modified or different ways of specific implementation. The iterations are in particular performed multiple times, for example 2 to 20 times, preferably 3 to 10 times, more preferably 4 to 8 times. In particular each of the two iterated reconstruction steps may be performed a number of times while alternating between the two steps.

Applying the extended conventional image reconstruction comprises applying a parallel imaging model. The parallel imaging model may comprise coil sensitivity maps. The coil sensitivity maps may be derived from reference data. Applying the parallel imaging model may comprise using a prior image estimate to calculate a new image (for example, ${x}_{n + 1 / 2}^{\left(c\right)}$ being calculated based on the prior image ${x}_{n}^{\left(c\right)}$ in equation [5]). Initially the prior image may be set randomly or by setting it to predefined values, such as to all zero. For example, in the above iteration including equation [5], an initial condition for the iteration may be set to be ${x}_{0}^{\left(c\right)} = 0$. During iteration, the prior image may in particular correspond to the output of the machine learning model. Hence, the machine learning model may output an adapted image that is used as input for the conventional imaging reconstruction during the next iterative step. The parallel imaging model in particular comprises a forward model relating the image to the acquired k-space data, in particular with a linear relation. The forward model may also be denoted as system operator. In the above equation [5], the forward model is denoted by the parameter *A*. Generally (not including contrast notation in this example for simplicity), such a forward model may be described as a linear relation in the compressed form $y = Ax ,$ wherein *x* is the image, *y* are the acquired *k*-space data, and *A* is the forward model. The forward model may comprise coil sensitivity information, in particular the coil sensitivity maps. Using the indices *I* for the receive channel, *k* and *p* for the k-space position as well as m for spatial coordinates, the forward model may be described based on the sum ${y}_{I , k} = {\sum }_{p , m} {P}_{k , p} {u}_{p , m} {C}_{I , m} {x}_{m} ,$ wherein ${P}_{k , p} = \left\{\begin{matrix}1 & , k = p and k acquired \\ 0 & , else\end{matrix}\right.$ is the projection on the sampled acquisitions, *u_{p,m}* are coefficients of a Fourier transform, and *C_{I,m}* are the coil sensitivity maps. Thus, the forward model may be described by the form ${A}_{I , k , m} = {\sum }_{p} {P}_{k , p} {u}_{p , m} {C}_{I , m} .$

The extended conventional image reconstruction may further comprise a regularization parameterized by a parameter to a prior image of the iteration, in particular a Tikhonov regularization term comprising a Tikhonov regularization parameter. Generally, the regularization regulates the currently generated image with respect to the prior image. The regularization parameter may correspond to as step size of the iteration step. For example, in the notation of equation [5], the regularization, in particular the Tikhonov regularization term, may be of the form $\frac{1}{{λ}_{n}^{2}} {\left‖{x}^{\left(c\right)}-{x}_{n}^{\left(c\right)}\right‖}^{2} ,$ with *λₙ* being the Tikhonov regularization parameter or step size. In particular, this Tikhonov regularization does not connect multiple contrasts but is applied for each contrast independently.

Next to applying the extended conventional image reconstruction, a further iteration step is to apply the trained machine learning model to enhance image data. The trained machine learning model is in particular trained to enhance the image output of the conventional image reconstruction. The output of the trained machine learning model is in particular the next prior image. Optionally, for each of the iterative steps of applying the trained machine learning model a different trained sub-model may be applied. In general, a trained machine learning model mimics cognitive functions that humans associate with other human minds. In particular, by training based on training data the machine learning model is able to adapt to new circumstances and to detect and extrapolate patterns. Another term for "trained machine learning model" is "trained function". In general, parameters of a machine learning model can be adapted by means of training. In particular, supervised training, semi-supervised training, unsupervised training, reinforcement learning and/or active learning can be used. Furthermore, representation learning (an alternative term is "feature learning") can be used. In particular, the parameters of the machine learning models can be adapted iteratively by several steps of training. In particular, within the training, a certain cost function can be minimized. In particular, within the training of a neural network, a backpropagation algorithm can be used. In particular, a machine learning model can comprise a neural network, a support vector machine, a decision tree and/or a Bayesian network, and/or the machine learning model can be based on k-means clustering, Q-learning, genetic algorithms and/or association rules. In particular, a neural network can be a deep neural network, a convolutional neural network or a convolutional deep neural network. Furthermore, a neural network can be an adversarial network, a deep adversarial network and/or a generative adversarial network.

The trained machine learning model used according to this invention may in particular be a deep-learning model. A deep-learning model typically comprises a neural network having multiple layers, i.e. typically having at least three layers. However, the neural network may also have significantly more than three layers, for example hundreds or even thousands of layers. Hence, the word deep refers to there being multiple layers. Alternative terms for "neural network" are "artificial neural network", "artificial neural net" or "neural net". For example, a deep-learning model may comprise a (deep) convolutional neural network and/or may comprise transformers. A convolutional neural network is a neural network that uses a convolution operation instead of a general matrix multiplication in at least one of its layers (the so-called "convolutional layer"). In particular, a convolutional layer performs a dot product of one or more convolution kernels with the convolutional layer's input data / image, wherein the entries of the one or more convolution kernel are the parameters or weights that are adapted by training. For example, the Frobenius inner product and the ReLU (rectified linear unit) activation function may be used. A convolutional neural network can comprise additional layers, e.g., pooling layers, fully connected layers, and normalization layers. By using convolutional neural networks, input images can be processed in a very efficient way, because a convolution operation based on different kernels can extract various image features, so that, by adapting the weights of the convolution kernel, the relevant image features can be found during training. Furthermore, based on the weight-sharing in the convolutional kernels, less parameters need to be trained, which prevents overfitting in the training phase and allows to have faster training or more layers in the network, improving the performance of the network.

According to this invention, the machine learning model may in particular comprise a U-net structure. Within the U-net structure, first the input image data is down-sampled (decreasing the size of the image data and increasing the number of channels), afterwards they are up-sampled (increasing the size of the images and decreasing the number of channels) to generate a transformed image. For example, a U-net with an architecture and trained as described in "Prospective Deployment of Deep Learning Reconstruction Facilitates Highly Accelerated Upper Abdominal MRI", Brendel, Jan M. et al., Academic Radiology, Volume 31, Issue 12, 4965 - 4973 may also be applied for this invention. The basic concepts of a U-net architecture and its implementation are described in Ronneberger, O., Fischer, P., Brox, T. (2015). U-Net: Convolutional Networks for Biomedical Image Segmentation. In: Navab, N., Hornegger, J., Wells, W., Frangi, A. (eds) Medical Image Computing and Computer-Assisted Intervention - MICCAI 2015. MICCAI 2015. Lecture Notes in Computer Science, vol 9351. Springer, Cham.

Generally, the machine learning model may be applied for all contrasts at once or the contrasts may be evaluated trough the machine learning model, in particular the same machine learning model for each contrast, independently. In particular the machine learning model may be configured to be applied separately for each contrast without further connecting the multiple contrasts. Hence, for example, a static training machine learning model may be applied for each contrast separately. A machine learning model that evaluates the contrasts independently, is typically easier to train. It has even been found that, in the context of this invention, the machine learning model does not necessarily have to be trained any different than a typical machine learning model of the state of the art trained for image reconstruction. Advantageously, even when evaluating the contrasts separately via the machine learning model, the different contrasts are still connected via the regularization. Advantageously, optionally, the method according to the invention may be used by applying an already existing, in particular static, trained machine learning model, therefore avoiding the need for carrying out a training and for requiring corresponding training data. However, a machine learning model may also be trained specifically to be applied in this inventive method.

According to an embodiment, the trained machine learning model is trained end-to-end over the whole iterative process such that the iterative machine-learning-based k-space-to-image reconstruction has been simultaneously updated during training. In particular the iterative steps of the iterative reconstruction may be updated simultaneously during training. For example, during training, the weights of the machine learning model may be adapted together with the regularization strength of the regularization. It has been found that training end-to-end can give particularly good results allowing a very good adaption of the parameters. Alternatively, the regularization strength parameter may be set heuristically. Optionally, the trained machine learning model is trained based on static imaging k-space data without separate contrasts.

The machine learning model may preferably be trained in a supervised manner. For each of the iterative steps of applying the trained machine learning model a different sub-model may be trained. The sub-models may be trained end-to-end, i.e., the sub-models may in particular be updated simultaneously during training. The machine learning model may in particular comprise a three-dimensional U-net architecture and be trained as described in "Prospective Deployment of Deep Learning Reconstruction Facilitates Highly Accelerated Upper Abdominal MRI", Brendel, Jan M. et al., Academic Radiology, Volume 31, Issue 12, 4965 - 4973. Hence, as described in this paper, for supervised training, for example 5000 pairs may be used that are derived from about 500 fully sampled datasets. The datasets may be obtained from volunteers (e.g. in head, abdomen, and pelvis) using magnetic resonance imaging scanners, such as 1.5 Tesla and/or 3 Tesla scanners. As loss function, a L1 metric may be used. As optimizer Adam may be used. The obtained intermediate images may be interpolated using a deep-learning-based super-resolution algorithm. The algorithm may initially perform a two-fold up-sampling, in particular in all spatial directions, and enforce data consistency on the acquired frequencies. According to an embodiment, the multiple contrasts correspond to multiple points in time, in particular different points in time. In other words, the contrast dimension may be time. Additionally, or alternative, the multiple contrasts may correspond to a phase dimension. Optionally, some of the multiple contrasts may correspond to multiple points in time and some of the multiple contrasts may correspond to a phase dimension. Examples, where the contrast dimension is time are GRASP (Golden-Angle Radial Sparse Parallel MRI), VIBE and CS VIBE (Compressed Sensing VIBE). GRASP is a dynamic contrast-enhanced magnetic resonance measurement technique using. Typically, when applying GRASP, during the entire examination, data is continuously acquired under contrast medium administration. For example, in particular combined with Compressed Sensing (CS) and parallel imaging, GRASP may be used to enable fast and flexible dynamic volumetric MR imaging, e.g. of the liver, during free breathing. VIBE is a MR measurement technology using a 3D imaging method with reduced acquisition time through data interpolation and/or partial Fourier method. VIBE is used primarily for dynamic contrast agent examinations in the abdomen. In particular VIBE may be combined with a Compressed Sensing technique (CS-VIBE). Optionally, GRASP may be combined with a Compressed Sensing technique and with VIBE (CS GRASP-VIBE). An example for the contrast dimension being phase is CS CINE that is used for displaying dynamic process, such as a heart movement. Preferably, (temporal) wavelets or total variation as described herein may be used as regularization if the contrast dimension is time. Preferably, (temporal) wavelets as described herein may be used as regularization if the contrast dimension is phase.

According to an embodiment, the regularization is a total variation regularization, in particular a temporal total variation regularization, a wavelet regularization, in particular a temporal wavelet regularization, and/or a locally low rank regularization. For example, temporal total variation may be used if the contrast dimension is time and/or if the contrast dimension is contrasts in a recovery experiment for parametric mapping. The term "total variation" may be abbreviated as "TV". The total variation regularization may in particular comprise an L1-norm. For example, the total variation regularization may be written as $R \left(\left\{{x}^{\left(c\right)}\right\}\right) = {{\sum }_{c = 1}^{c = {N}_{c} - 1} \left‖{x}^{\left(c+1\right)}-{x}^{\left(c\right)}\right‖}_{1}$

For example, temporal wavelet regularization may be used if the contrast dimension is time and/or phase. The wavelet may be a product of contrast dimension and spatial dimension. The wavelet regularization may in particular comprise an L1-norm. For example, the wavelet regularization may be written as $R \left(\left\{{x}^{\left(c\right)}\right\}\right) = {\left‖{\sum }_{c} {W}_{c} {x}^{\left(c\right)}\right‖}_{1}$

For the wavelets the contrast direction as well as the spatial direction may be taken as transform dimensions. In other words, in the above equation, the operator *W_{c}* is acting in the spatial domain and may present wavelet decomposition with an additional weighting (determining the spatial regularization strengths) and also couples the different contrasts. The output of ∑*_{c} W_{c}x*^{(*c*)} is typically a tensor of the wavelet decomposition acting both in spatial and contrast dimension and therefore may also have spatial and contrast indices. In this example, only the right contrast index is explicitly shown as the input is defined as a set. For example, locally low rank regularization may be used if the contrast dimension is different flip angles, repetition times and/or different echo times. The term "locally low rank" may be abbreviated as "LLR". The locally low rank regularization may in particular comprise a nuclear norm. The nuclear norm is also referred to as trace norm. The nuclear norm is typically denoted by a low asterisk symbol (*). For example, the locally low rank regularization may be written as $R \left(\left\{{x}^{\left(c\right)}\right\}\right) = {\sum }_{b} {\left‖{B}_{b}\left(\left\{{x}^{\left(c\right)}\right\}\right)\right‖}_{∗}$

In particular, for the locally low rank regularization first two-dimensional patches may be formed with spatial and contrast dimension denoted by the operator *B_{b}*(*.*) in above equation for each patch b and then the nuclear norm may be applied. The operator *B_{b}*(*.*) may be a reshape operator used for correlating small image regions with a number of elements of all contrasts. For example, the operator *B_{b}*(*.*) may be defined according to equation (11) in E. J. Candès, C. A. Sing-Long and J. D. Trzasko, "Unbiased Risk Estimates for Singular Value Thresholding and Spectral Estimators," in IEEE Transactions on Signal Processing, vol. 61, no. 19, pp. 4643-4657, Oct.1, 2013, doi: 10.1109/TSP.2013.2270464. For example, in the context of a neural network, this may be done by unfolding which extracts kernels/patches for convolution. Information about the context of LLR can be found in the publication Lugauer, Felix & Nickel, Dominik & Wetzl, Jens & Kannengiesser, Stephan & Maier, Andreas & Hornegger, Joachim. (2015). Robust Spectral Denoising for Water-Fat Separation in Magnetic Resonance Imaging. 667-674. 10.1007/978-3-319-24571-3_80.

According to an embodiment, the multiple contrasts correspond to contrasts in a recovery experiment for parametric mapping. In this case, in particular, the regularization may be a temporal total variation regularization. With parametric mapping, in particular T1-mapping such as volumetric T1-mapping, the return of magnetization to an equilibrium state is observed. For this purpose, usually inversion contrasts are obtained. It has been found that the method according to this invention can work well for contrasts in a recovery experiment for parametric mapping, in particular when using a total variation regularization. An example for volumetric T1-mapping is explained in Lugauer, F., Wetzl, J., Forman, C. et al. Single-breath-hold abdominal mapping using 3D Cartesian Look-Locker with spatiotemporal sparsity constraints. Magn Reson Mater Phy 31, 399-414 (2018).https://doi.org/10.1007/s10334-017-0670-8.

According to an embodiment, the multiple contrasts correspond to different flip angles, different repetition times and/or different echo times used in the acquisition of the k-space data. In this case, the regularization is in particular a locally low rank regularization. The repetition time is generally the time between two excitation pulses. Repetition time typically is one measurement parameter that determines the contrast of the measurement. Typically, the flip angle of a gradient-echo sequence generating the maximum signal with a specific T1 depends on the repetition time. An example for the application of different flip angles or different repetition times is variable flip angle T1 mapping (VFA T1 mapping). Variable flip angles may allow for very high turbo factors and high sampling efficiencies. Different echo times may correspond to a multi-echo sequence. Applying a multi-echo sequence is an MRI measurement technique using a pulse sequence that acquires multiple echoes with different degrees of T2 weighting. Different echo times may, for example, be used in multi-echo Dixon imaging. Multi-echo Dixon imaging is an MRI measurement technique used to determine a fat fraction, in particular for separating water and fat tissue. The application of LLR on Dixon imaging is described in Lugauer, Felix & Nickel, Dominik & Wetzl, Jens & Kannengiesser, Stephan & Maier, Andreas & Hornegger, Joachim. (2015). Robust Spectral Denoising for Water-Fat Separation in Magnetic Resonance Imaging. 667-674. 10.1007/978-3-319-24571-3_80.

According to an embodiment, a sampling pattern of the k-space data is varied between the multiple contrasts. For example, the sampling pattern may be randomized and may be varied by having the same density but another randomization. Typically, the less dense a sampling pattern is, the less information is included in the acquired data but the faster the acquisition can be performed. Hence, greater non-sampled gaps in k-space may lead to a faster acquisition but worse results in calculating points of data. Advantageously, varying the sampling pattern allows to compensate for gaps in sampling since the data of the multiple contrasts are connected via the regularization and, thus, information from different contrasts combined may allow to have a better-defined problem, i.e., a better, more accurate solution may be obtainable. According to an embodiment, the sampling pattern of at least some of the multiple contrasts, in particular all of the multiple contrasts, is an irregular sampling pattern. An irregular sampling pattern may also be denoted as incoherent sampling pattern. An irregular sampling pattern can be understood in contrast to a regular sampling pattern. A regular sampling pattern is uniform, such that the distances between neighbouring sampling points are equal. Generally, an irregular sampling pattern in k-space means that the distances between neighbouring sampling points are not uniform but vary over a k-space grid. An irregular sampling pattern may be a randomized or pseudo-randomized sampling pattern. Hence the sampling points may be chosen randomly or randomly with certain constraints. The irregular sampling pattern of at least some of the contrasts may itself have a variable sampling density. For example, the irregular sampling pattern may have a higher sampling density close to a central part of k-space and a lower sampling density at the outer parts (periphery) of k-space. Typically, more relevant information is contained in the centre of k-space than at the outer parts of k-space. The irregular sampling pattern may be a combination of a regular sampling pattern and irregular sampling pattern. A regular sampling pattern is in particular used in parallel imaging. A regular sampling pattern in particular means that the acquisition is sped up by decreasing the sampling (i.e. under-sampling) but the sampling pattern is uniform, such that the distances between neighbouring sampling points are equal. Using irregular sampling allows to reduce the acquisition time of the MR acquisition. Optionally, the data, based on the irregular sampling pattern may be adapted to be more suitable for trained machine learning models. For example, this can be achieved by adapting the data to correspond more closely to training data the trained machine learning model has been trained with. In particular, the machine learning model may be trained with data that is suitable for the machine learning model, such as more uniform data having a more regular sampling pattern, and then, during application, the acquired data with irregular sampling pattern may be adapted to come close to the training data, in particular be more regular. For example, at least one additional reconstruction step may be performed before starting to iterate between the reconstruction steps in order to adapt the data. For example, adapting data may comprise synthesizing k-space data for at least some missing data points of the irregular sampling pattern and supplementing the acquired k-space data with the synthesized k-space data in order to generate k-space data that are more uniform and closer to an under-sampling of regular parallel imaging k-space data, in particular essentially completely uniform and equivalent to the under-sampling of regular parallel imaging k-space data.

According to an embodiment, a user is given the option via a user interface input to set a regularization strength of the regularization and/or to choose from multiple types of regularizations to be used for the added regularization, wherein the input from the user is received and the regularization strength and/or the type of regularization is applied according to the user's input. For example, the regularization strength may correspond to the parameter *α* in equation [5] given above. For example, the user may be given the option to choose between a set of different regularization strengths. The set of different regularization strengths may comprise a set number of different regularization strength. For example, the set number may be in the range of 3 to 10, such as 5 different regularization strengths. For example, the set of different regularization strengths may comprise different settings, such as "high regularization strength", "medium regularization strength", etc. The multiple types of regularizations may in particular comprise one or several of the types described herein, such as total variation regularization, wavelet regularization or locally low rank regularization. Advantageously, the method may thus be particularly well adaptable to specific requirements of a user.

According to an embodiment, the conventional image reconstruction is further extended by a further regularization that is acting in a spatial domain. Optionally, the further regularization may be scaled by a further regularization strength. Advantageously, the spatial characteristics of resulting images may be further improved by the further regularization.

According to an embodiment, applying the extended conventional image reconstruction comprises optimizing a cost function, the cost function comprising the regularization. The cost function may be of the type argmin. The cost function may in particular be optimized, in particular minimized, with respect to the real space image data. For example, the cost function may correspond to the function ${argmin}_{{x}^{\left(c\right)}} \left(.\right)$ as in equation [5] described above. Optionally, the optimization of the cost function may itself comprise a further iterative process, in particular an inner iterative process. In particular the inner iterative process may be an inner iterative process corresponding to an outer iterative process, wherein the outer iterative process is the iterative machine-learning-based k-space-to-image reconstruction iterating between reconstruction steps of applying the extended conventional image reconstruction and applying the trained machine learning model. The inner iterative process may comprise an inner iteration loop. The outer iterative process may comprise an outer iteration loop. Optionally, the number of iterations of the further iterative process may vary, in particular depending on the number of iterations of the outer iterative process. For example, the number of iterations of the further iterative process may be lower for earlier iterations of the outer iterative process than for later iterations of the outer iterative process.

According to an embodiment, applying the extended conventional image reconstruction may comprise applying a method based on a gradient descent, in particular by applying a proximal operator. Applying the extended conventional image reconstruction may in particular comprise calculating a gradient of a term comprising the parallel imaging model and calculating or approximating a proximal operator of a function comprising the regularization. The gradient and the proximal operator may be calculated sequentially.

According to an embodiment, applying the extended conventional image reconstruction comprises applying an inner iteration loop. Correspondingly, there may be the inner iteration loop and an outer iteration loop, the outer iteration loop comprising performing the inner iteration loop in order to apply the extended conventional image reconstruction and applying the trained machine learning model to enhance image data. The inner iteration loop may comprise applying a method based on a gradient descent, in particular by applying a proximal operator. The inner iteration loop may in particular comprise calculating a gradient of a term comprising the parallel imaging model and calculating or approximating a proximal operator of a function comprising the regularization. The gradient and the proximal operator may be calculated sequentially. The gradient and/or the proximal operator (preferably both) may be calculated at a predetermined point corresponding to an image estimate, in particular based on the current iteration stage of the image estimate. The predetermined point does not have to be the current image estimate of the iteration. The predetermined point being the current image estimate in particular corresponds to applying a simple gradient descent. In particular the predetermined point may be a linear combination taking into account the current iterative image estimate and the previous iterative image estimate. This may be described as a gradient descent with momentum. It has been found that such an approach can allow to achieve results particularly efficiently requiring relatively little calculating capacity while generating good results. For example, calculating the gradient may be performed by a term such as $∇ \left({\left‖Ax-y\right‖}^{2}+\frac{1}{{λ}_{n}^{2}}{\left‖x-{z}_{n}\right‖}^{2}\right) .$

Calculating or approximating the proximal operator may be performed by a term such as ${argmin}_{x} \left({\left‖x-x′\right‖}^{2}+\frac{1}{L}R\left(x\right)\right) ,$ wherein 1/*L* is the step size. The step size 1/*L* may be an inverse Lipshitz constant, in particular of the operator *A*. The step size may be 1. For example, a fast iterative shrinkage-thresholding algorithm (FISTA) may be used. An example of how FISTA may be applied is explained in the publication "A Fast Iterative Shrinkage-Thresholding Algorithm for Linear Inverse Problems" by Amir Beck and Marc Teboulle, SIAM Journal on Imaging Sciences 2009 2:1, 183-202 (https://doi.org/10.1137/080716542).

According to an embodiment, during iterative machine-learning-based k-space-to-image reconstruction, a CPU (central processing unit) RAM (random-access memory) is used as buffer and data for the reconstruction steps or parts of the reconstruction steps of the iteration are streamed to a GPU (graphics processing unit) for processing, in particular by copying respective data from the CPU to the GPU for processing on the GPU and copying back results of the processing to the CPU for each reconstruction step or part of the reconstruction step. Typically, a CPU has a larger RAM (for example, 48 Gb RAM) then a GPU (for example in the range of 4 to 8 Gb RAM). On the other hand, the GPU is more suitable to actually perform the processing of the data according to this method. It has been found that streaming data between the CPU and the GPU can allow a particularly efficient processing of the data in the context of the method by optimally using the advantages of both, the CPU and the GPU for the particular requirements of the method. Therein, the larger RAM of the CPU can be used to enable faster processing larger chunks of data that might otherwise be limited by the GPU's RAM. In particular, only parts of the complete amount of data may be copied from the CPU to the GPU each time. Before streaming another chunk of data, the GPU's RAM may in particular be deleted after copying the result back to the CPU. For example, corresponding data may be streamed to the GPU for applying the extended conventional image reconstruction and, separately, corresponding data may be streamed to the GPU for applying the trained machine learning model. It may be provided that data for applying part of the extended conventional image reconstruction is streamed to the GPU and, consecutively, data for applying at least one other part of the extended conventional image reconstruction is streamed to the GPU. For example, data for applying the parallel imaging model (optionally regularized by an additional by a regularization parameterized by a parameter to a prior image of the iteration, in particular a Tikhonov regularization term comprising a Tikhonov regularization parameter) may be streamed to the GPU and, then, data for applying the added regularization that connects multiple contrasts may be streamed to the GPU. For example, a first part of equation [5] above, such as the part corresponding to the term $\left({\left‖{Ax}^{\left(c\right)}-{y}^{\left(c\right)}\right‖}^{2}+\frac{1}{{λ}_{n}^{2}}{\left‖{x}^{\left(c\right)}-{x}_{n}^{\left(c\right)}\right‖}^{2}\right) ,$ may be streamed to the GPU for calculation and, then, another part of equation [5], such as the part corresponding to the term $α R \left(\left\{{x}^{\left(c\right)}\right\}\right)$ may be streamed to the GPU. Optionally, corresponding data may be streamed to the GPU for calculating a gradient of a term comprising the parallel imaging model and, consecutively, corresponding data may be streamed to the GPU for calculating or approximating a proximal operator of a function comprising the regularization. Optionally, applying the trained machine learning model may be performed in sub-volumes by consecutively streaming data corresponding to the sub-volumes to the GPU. For example, the sub-volumes may correspond to the different contrasts of the multiple contrasts. Advantageously, such sub-volumes corresponding to the different contrasts are typically translationally invariant and therefore suitable to be processed by the machine learning model separately. This separation into sub-volumes allows a particularly efficient processing of the multiple contrasts, e.g. enabling the use of more powerful and/or complex models.

According to a further aspect of the invention, a method for generating magnetic resonance image data is provided. The method comprises the steps of
- acquiring multi-contrast k-space data via a magnetic resonance imaging system at multiple contrasts;
- performing a method as described herein on the acquired multi-contrast k-space data.

All features and advantages of the method for reconstructing image data may be adapted to the method for generating magnetic resonance image data and vice versa.

According to an embodiment, the multi contrast k-space data is acquired with an irregular sampling pattern, such that he applied sampling pattern of at least some of the multiple contrasts, in particular all of the multiple contrasts, is an irregular sampling pattern.

According to an embodiment, the k-space data is acquired with an irregular sampling pattern such that a regular sampling pattern that is further modified by an irregular sampling pattern is acquired so that the acquired irregular sampling pattern is a combination of a regular sampling pattern and an irregular sampling pattern.

According to an embodiment, during acquisition of the k-space data, an applied sampling pattern is varied between the multiple contrasts such that at least some of the multiple contrasts, in particular all of the multiple contrasts, do not have the same sampling pattern.

According to a further aspect of the invention, a computer program or computer-readable storage medium, in particular non-transient storage medium, comprising instructions which, when executed by a computer, cause the computer to carry out the method of any one of the preceding claims. The storage medium may be any computer-readable storage medium. For example, the storage medium may be an optical storage medium or a solid-state storage medium. The storage medium may, be a hard-drive, a solid-state-disk a flash storage an online server etc. All features and advantages of the method for reconstructing image data and of the method for generating magnetic resonance image data may be adapted to the computer program or computer-readable storage medium and vice versa.

According to a further aspect of the invention, a magnetic resonance imaging system configured to carry out any of the methods as described herein and/or comprising a processing unit that is configured to carry out any of the methods as described herein is provided. All features and advantages of the method for reconstructing image data, of the method for generating magnetic resonance image data and of the computer program or computer-readable storage medium may be adapted to the magnetic resonance imaging system and vice versa.

According to a further aspect of the invention, a processing unit that is configured to carry out the method as described herein is provided. All features and advantages of the method for reconstructing image data, of the method for generating magnetic resonance image data, of the computer program or computer-readable storage medium and of the magnetic resonance imaging system may be adapted to the processing unit and vice versa.

The embodiments described herein may be combined with each other unless indicated otherwise.

The accompanying drawings illustrate various exemplary embodiments and methods of various aspects of the invention.
Fig. 1 shows a flow diagram of a computer-implemented method for reconstructing image data from multi-contrast magnetic resonance k-space data using a trained machine learning model according to an embodiment of the invention;
Fig. 2 shows a flow diagram of a computer-implemented method for reconstructing image data from multi-contrast magnetic resonance k-space data using a trained machine learning model according to an embodiment of the invention;
Fig. 3 shows a flow diagram of a computer-implemented method for reconstructing image data from multi-contrast magnetic resonance k-space data using a trained machine learning model according to an embodiment of the invention;
Fig. 4 shows a flow diagram of a method for generating magnetic resonance image data according to an embodiment of the invention; and
Fig. 5 shows a magnetic resonance imaging system according to the invention configured to carry out any of the methods according to this invention.

Similar elements are designated with the same reference signs in the drawings.

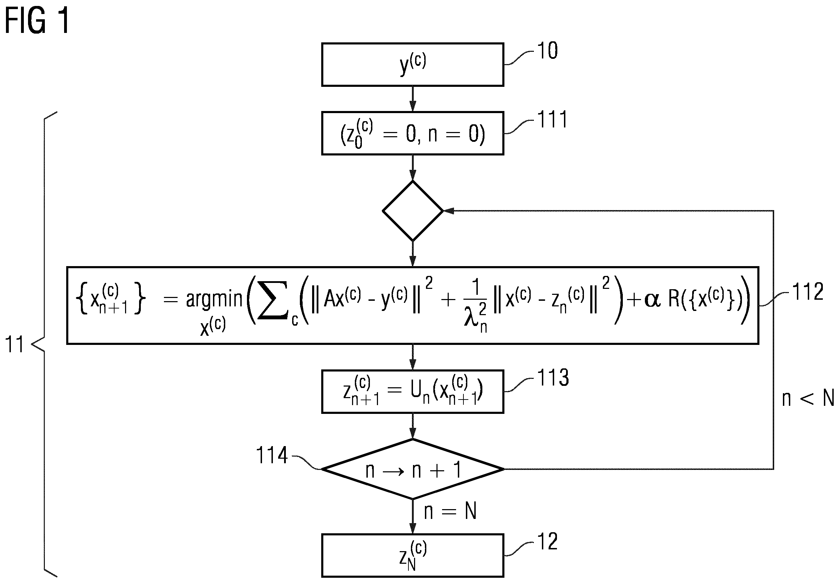

Figure 1 shows a flow diagram of a computer-implemented method for reconstructing image data from multi-contrast magnetic resonance k-space data using a trained machine learning model according to an embodiment of the invention. The trained machine learning model may in particular be a trained deep-learning model. In a first step 10 of the method, multi-contrast k-space data (here denoted by the parameter *y*^{(*c*)}) acquired with multiple contrasts are received. The multiple contrasts may in particular correspond to multiple points in time or to a phase dimension. For example, the multiple contrasts may correspond to contrasts in a recovery experiment for parametric mapping, to different flip angles, different repetition times and/or different echo times used in the acquisition of the k-space data. In the following step 11, an iterative machine-learning-based k-space-to-image reconstruction is performed on the acquired multi-contrast k-space data. The iterative machine-learning-based k-space-to-image reconstruction as shown here may in particular correspond to an unrolled machine learning network. The iterative machine-learning-based k-space-to-image reconstruction comprises iterating between reconstruction steps of applying an extended conventional image reconstruction and applying the trained machine learning model. For this purpose, in an initialization step 111, a counting variable *n* and initial images ${z}_{0}^{\left(c\right)}$ (for each contrast *c*) are set.

For example, the initial images and the counting variable may all be set to zero as shown in this flow diagram. The initial image *z*₀ being set to zero in particular means that all its image values are set to zero. After initialization 111, the step 112 of applying an extended conventional image reconstruction is applied. The extended conventional image reconstruction involves a parallel imaging model that relates image data to k-space data independently for each contrast. The parallel imaging model is, in this example expressed by the term ${\left‖{Ax}^{\left(c\right)}-{y}^{\left(c\right)}\right‖}^{2} + \frac{1}{{λ}_{n}^{2}} {\left‖{x}^{\left(c\right)}-{z}_{n}^{\left(c\right)}\right‖}^{2}$ wherein *n* indexes the current iteration step, A denotes a system operator corresponding to the parallel imaging model that connects the acquired k-space data and a reconstructed image x and *λₙ* is a regularization parameter. The conventional image reconstruction is extended by an added regularization *R*({*x*^{(*c*)}}) that connects the multiple contrasts (*c*). For example, the regularization may be a total variation regularization, wavelet regularization, or a locally low rank regularization. Optionally, a user may be given the option via a user interface input to choose from multiple types of regularizations to be used, i.e. applied for the iterative step(s) 112. The regularization may be controlled by a regularization strength *α*. The regularization strength may be applied to be the same for each iterative step 112. Alternatively, the regularization strength may be different for at least some or all of the iterative steps 112. The regularization strength may be adapted together with the training parameters of the machine learning model during training of the machine learning model. Optionally, a user may be given the option via a user interface input to set the regularization strength of the regularization. For example, the user may input a value for the regularization strength or choose from a range of available regularization strengths. In this optional variant, the input from the user is received and the regularization strength is applied according to the user's input. Optionally, the conventional image reconstruction may be further extended by a further regularization that is acting in a spatial domain. The output of this current iteration step 112 is the image estimate ${x}_{n + 1}^{\left(c\right)}$. The output may be determined by optimizing a cost function that comprises the regularization. For example, as shown in this case, the output may be is determined based on the applied minimization function "argmin". The image estimate ${x}_{n + 1}^{\left(c\right)}$ comprises in particular one image estimate for each contrast. The output of this iteration step 112 (i.e., ${x}_{n + 1}^{\left(c\right)}$) is then used in the next step 113 of applying the trained machine learning model. During this step 113, the trained machine learning model is applied on the output ${x}_{n + 1}^{\left(c\right)}$ of the previous step 112 in order to generate enhanced image data ${z}_{n + 1}^{\left(c\right)}$ for each contrast. The enhanced image data may also be denoted as a prior image estimate. For this purpose, preferably a neural network, in particular a deep neural network, may be applied. The machine learning model may optionally be applied separately for each contrast. Optionally, a different machine learning model may be applied for each iterative step 113. For example, the different machine learning models may be specifically trained for each iterative step *n.* In a further step 114, the counting variable *n* is increased, typically by 1, and the iterative steps 112, 113, 114 are repeated until the counting variable reaches a predetermined value (here denoted as N). Hence, until the end of the iterative process, in step 112, the enhanced image data generated in the respective previous iterative step 113 is used as input. When the iterative process is finished, i.e., in this example, when the condition *n* = *N* is reached, the reconstructed image data ${z}_{N}^{\left(c\right)}$ generated at the last iterative step 113 of applying the trained machine learning model is provided in a further step 12.

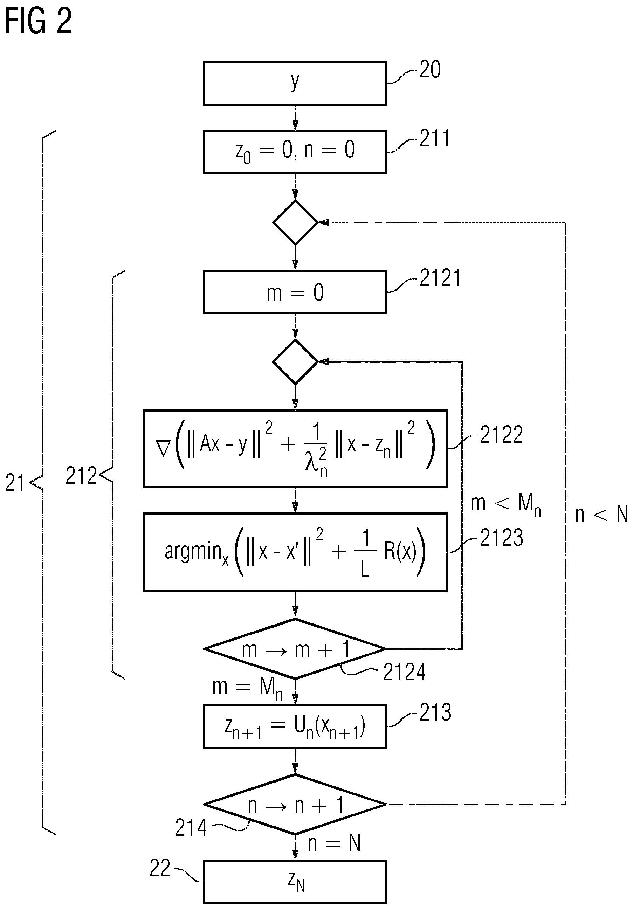

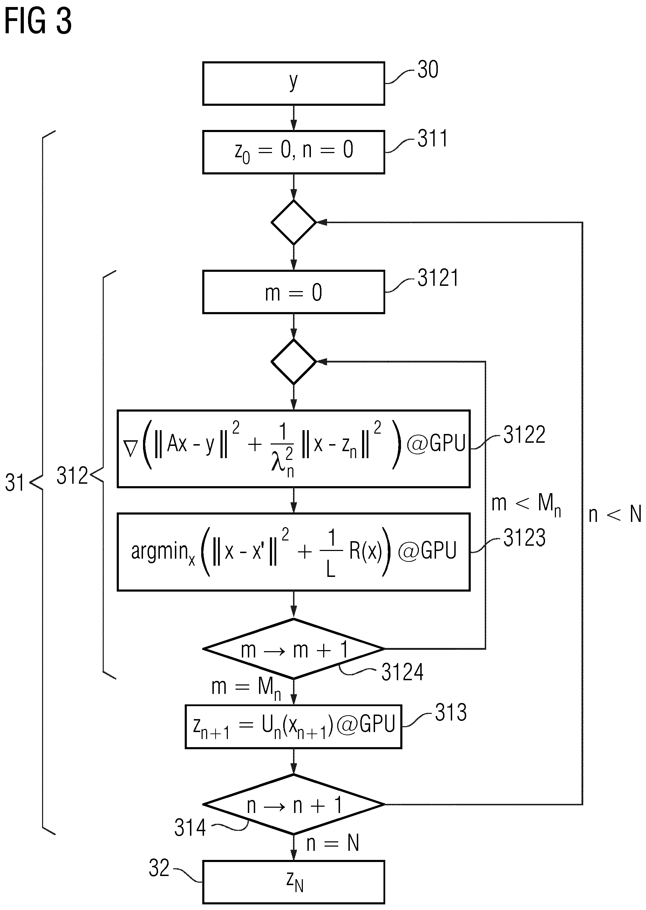

Figure 2 shows a flow diagram of a computer-implemented method for reconstructing image data from multi-contrast magnetic resonance k-space data using a trained machine learning model according to an embodiment of the invention. The trained machine learning model may in particular be a trained deep-learning model. In a first step 20 of the method, multi-contrast k-space data (here denoted by the parameter *y*) acquired with multiple contrasts are received. The multiple contrasts may in particular correspond to multiple points in time or to a phase dimension. For example, the multiple contrasts may correspond to contrasts in a recovery experiment for parametric mapping, to different flip angles, different repetition times and/or different echo times used in the acquisition of the k-space data. In the following step 21, an iterative machine-learning-based k-space-to-image reconstruction is performed on the acquired multi-contrast k-space data. The iterative machine-learning-based k-space-to-image reconstruction as shown here may in particular correspond to an unrolled machine learning network. The iterative machine-learning-based k-space-to-image reconstruction comprises iterating between reconstruction steps of applying an extended conventional image reconstruction and applying the trained machine learning model. This iteration is performed according to an outer iteration loop. At the beginning of this step 21 of applying an outer iteration loop, in an initialization step 211, a counting variable *n* and an initial image *z*₀, in particular an initial image for each of the multiple contrasts, are set. The initial image may be set to the same values for all of the multiple contrasts. For example, the initial images and the counting variable may all be set to zero as shown in this flow diagram. The initial image *z*₀ being set to zero in particular means that all its image values are set to zero. After initialization 211, a step 212 of applying an extended conventional image reconstruction is applied. In this embodiment, applying the extended conventional image reconstruction comprises applying an inner iteration loop. Therefore, in an initialization step 2121 of the inner loop, a further counting variable (*m*) is initialized. For example, the further counting variable may be set to zero as shown in this flow diagram. Optionally, further variables may be initialized in this step such as setting an image estimate to a particular value, such as setting the image estimate to all zero. In a further step 2122, the inner iteration loop comprises calculating a gradient of a term comprising a parallel imaging model that relates image data to k-space data independently for each contrast. In this example this is performed via the term $∇ \left({\left‖Ax-y\right‖}^{2}+\frac{1}{{λ}_{n}^{2}}{\left‖x-{z}_{n}\right‖}^{2}\right) ,$ wherein *n* indexes the current iteration step, *A* denotes a system operator corresponding to the parallel imaging model that connects the acquired k-space data and a reconstructed image *x* and *λₙ* is a regularization parameter. This term may be applied for each contrast, in particular consecutively for each contrast. Here, in the notation of this embodiment a contrast notation (e.g., *x*^{(*c*)} etc.) as in figure 1 is not used for the sake of simplicity. However, a corresponding notation may be applied here analogously. In a further step 2123, a proximal operator of a function comprising the regularization *R*(*x*) (which may also be denoted as *R*({*x*^{(*c*)}}) as shown in the example of figure 1) is calculated or approximated. The regularization connects the multiple contrasts. For example, the regularization may be a total variation regularization, wavelet regularization, or a locally low rank regularization. This approximation is performed via the term ${argmin}_{x} \left({\left‖x-x′\right‖}^{2}+\frac{1}{L}R\left(x\right)\right)$ with 1/*L* being a step size. The step size 1/*L* may be an inverse Lipschitz constant of the operator *A*. The output of this step 2123 is an image estimate. In the following steps 2122 of the inner iteration loop for calculating the gradient, this output image estimate may be used as a predetermined point at which the gradient is calculated. Preferably, this predetermined point may be a linear combination taking into account the current iterative image estimate and the previous iterative image estimate. In a further step 2124, the further counting variable (*m*) is increased and the steps 2122, 2123 of the inner iteration loop are repeated until a predetermined value (*m* = *Mₙ*) of the running variable, the predetermined value defining the numbers of iterative steps of the inner loop, is reached. The number of iterations of the inner iteration loop may be the same but does not have to be the same as the number of iterations of the outer iteration loop. The number of iterations of the inner iteration loop may vary. For example, more inner iteration steps may be needed for the earlier outer iteration steps. Hence, *Mₙ* may be different for each applied inner iteration loop over the course of the outer iteration loop. After completion of a respective inner loop, the output of this outer iteration step 212 is an image estimate (*x*_{*n*+1}) for each of the multiple contrasts. This output is then used in the next step 213 of applying the trained machine learning model. During this step 213, the trained machine learning model is applied on the output of the previous step 212 in order to generate enhanced image data *z*_{*n*+1} for each of the multiple contrasts. The enhanced image data may also be denoted as a prior image estimate. For this purpose, preferably a neural network, in particular a deep neural network, may be applied. The machine learning model may in particular be applied separately for each contrast. Optionally, a different machine learning model may be applied for each iterative step 213. In a further step 214, the counting variable *n* is increased, typically by 1, and the iterative steps 212 of applying an inner loop as well as the steps 213, 214 of applying the machine learning model and increasing the counting variable (*n* → *n +* 1) are repeated until the counting variable reaches a predetermined value (here denoted as *N*). When the iterative process is finished, i.e., in this example, when the condition *n* = *N* is reached, the reconstructed image data *z_{N}* generated at the last iterative step 213 of applying the trained machine learning model is provided in a further step 22. Generally, this embodiment described with respect to figure 2 may be seen as a specific embodiment of the embodiment shown in figure 1. All the features that are described with respect to figure 1 may generally and analogously also be applied for this embodiment. Via the inner iteration loop, a particularly efficient calculation of the first iterative step of the outer iteration loop is provided. This process may be implemented particularly well with currently available hardware, i.e. available GPUs and CPUs. An example of such an implementation is described with respect to figure 3.

Figure 3 shows a flow diagram of a computer-implemented method for reconstructing image data from multi-contrast magnetic resonance k-space data using a trained machine learning model according to an embodiment of the invention. This embodiment may be seen as a specific embodiment of the embodiment described with respect to figure 2. In particular, the features and details described with respect to figure 2 may be applied here as well. In a first step 30 of the method, multi-contrast k-space data (here denoted by the parameter *y*) acquired with multiple contrasts are received. In the following step 31, an iterative machine-learning-based k-space-to-image reconstruction is performed on the acquired multi-contrast k-space data. The iterative machine-learning-based k-space-to-image reconstruction comprises iterating between reconstruction steps of applying an extended conventional image reconstruction and applying the trained machine learning model. This iteration is performed according to an outer iteration loop. During this iterative reconstruction a CPU RAM is used as a buffer and individual pieces of data for the reconstruction steps are streamed to a GPU for processing. At the beginning of this step 31 of applying an outer iteration loop, in an initialization step 311, a counting variable *n* and an initial image *z*₀, in particular an initial image for each of the multiple contrasts, are set. After initialization 311, a step 312 of applying an extended conventional image reconstruction is applied. In this embodiment, applying the extended conventional image reconstruction comprises applying an inner iteration loop. Therefore, in an initialization step 3121 of the inner loop, a further counting variable (*m*) is initialized. In a further step 3122, the inner iteration loop comprises calculating a gradient of a term comprising a parallel imaging model that relates image data to k-space data independently for each contrast by a GPU. For this purpose, respective data is copied from the CPU to the GPU for processing on the GPU. The GPU then performs the processing, i.e., in this example, via a term of the form $∇ \left({\left‖Ax-y\right‖}^{2}+\frac{1}{{λ}_{n}^{2}}{\left‖x-{z}_{n}\right‖}^{2}\right) .$

After the calculation the result of the calculation is copied back to the CPU. This step 3122 of streaming, calculating and copying back the result is preferably performed consecutively for each contrast individually. In a further step 3123, a proximal operator of a function comprising the regularization *R*(*x*) as shown in the example of figure 1) is calculated or approximated. Again, for this purpose, respective data is copied from the CPU to the GPU for processing on the GPU, e.g., by a term such as ${argmin}_{x} \left({\left‖x-x′\right‖}^{2}+\frac{1}{L}R\left(x\right)\right) ,$ and the result is copied back to the CPU. In particular, this step 3123 of streaming, calculating and copying back the result may be performed consecutively for each contrast individually. The output of this step 3123 is an image estimate. In the following steps 3122 of the inner iteration loop for calculating the gradient, this output image estimate may be used as a predetermined point at which the gradient is calculated. Preferably, this predetermined point may be a linear combination taking into account the current iterative image estimate and the previous iterative image estimate. In a further step 3124, the further counting variable (*m*) is increased and the steps 2122, 2123 of the inner iteration loop are repeated until a predetermined value (m = *Mₙ*) of the running variable, the predetermined value defining the numbers of iterative steps of the inner loop, is reached. After completion of a respective inner loop, the output of this outer iteration step 312 is an image estimate (*x*_{*n*+1}) for each of the multiple contrasts. This output is then used in the next step 313 of applying the trained machine learning model. During this step 313, the output of the previous step 312 is streamed to the GPU and the trained machine learning model is applied on this output in order to generate enhanced image data *z*_{*n*+1} for each of the multiple contrasts. The machine learning model may in particular be applied separately for each contrast. Hence, the trained machine learning model may be applied separately for each contrast while only the necessary data corresponding to the currently processed contrast is on the GPU each time. Optionally, a different machine learning model may be applied for each iterative step 313. In a further step 314, the counting variable *n* is increased, typically by 1, and the iterative steps 312 of applying an inner loop as well as the steps 313, 314 of applying the machine learning model and increasing the counting variable (*n* → *n* + 1) are repeated until the counting variable reaches a predetermined value (here denoted as N). When the iterative process is finished, i.e., in this example, when the condition *n* = *N* is reached, the reconstructed image data *z_{N}* generated at the last iterative step 313 of applying the trained machine learning model is provided in a further step 32.

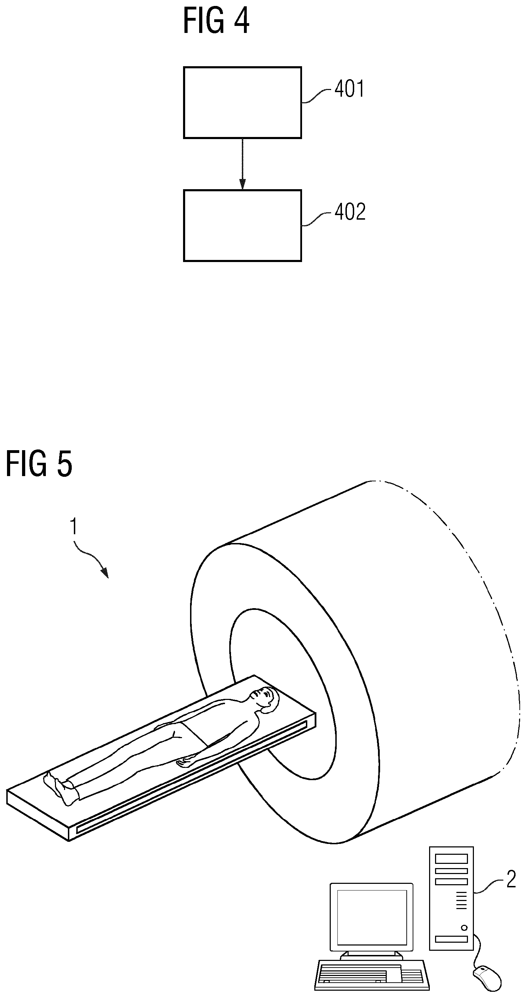

Figure 4 shows a flow diagram of a method for generating magnetic resonance image data according to an embodiment of the invention. The method comprises a step 401 of acquiring multi-contrast k-space data via a magnetic resonance imaging system at multiple contrasts. During acquisition the sampling pattern of the k-space data may optionally be varied between multiple contrasts. Additionally or alternative, the sampling pattern may be set such, that the sampling pattern of at least some of the multiple contrasts, in particular all of the multiple contrasts, is an irregular sampling pattern. In a further step 402 a method for reconstructing image data from multi-contrast magnetic resonance k-space data according to this invention is performed. For example, the further step 402 may comprise the steps of any of the embodiments described with respect to any of figures 1 to 3.

Figure 5 shows a magnetic resonance imaging system 1 configured to carry out any of the methods according to this invention. The magnetic resonance imaging system comprises a processing unit that is configured to carry out the method according to any of the methods of this invention. For example, the processing unit may be configured to carry out the method as described with respect to any one of the figures 1 to 4.

## Claims

1. A computer-implemented method for reconstructing image data from multi-contrast magnetic resonance k-space data using a trained machine learning model, in particular a trained deep-learning model, the method comprising:
(a) receiving acquired multi-contrast k-space data acquired with multiple contrasts;
(b) in order to generate image data, performing an iterative machine-learning-based k-space-to-image reconstruction on the acquired multi-contrast k-space data comprising iterating between reconstruction steps of
- applying an extended conventional image reconstruction involving a parallel imaging model, the parallel imaging model relating image data to k-space data independently for each contrast, wherein the conventional image reconstruction is extended by an added regularization that connects the multiple contrasts, and
- applying the trained machine learning model to enhance image data.

2. The method according to claim 1,
wherein the multiple contrasts correspond to multiple points in time, or
wherein the multiple contrasts correspond to a phase dimension.

3. The method according to any one of the preceding claims,
wherein the regularization is
- a total variation regularization, in particular a temporal total variation regularization,
- a wavelet regularization, in particular a temporal wavelet regularization, and/or
- a locally low rank regularization.

4. The method according to any one of the preceding claims,
wherein the multiple contrasts correspond to contrasts in a recovery experiment for parametric mapping,
wherein the regularization is in particular a temporal total variation regularization.

5. The method according to any one of the preceding claims,
wherein the multiple contrasts correspond to different flip angles, different repetition times and/or different echo times used in the acquisition of the k-space data,
wherein the regularization is in particular a locally low rank regularization.

6. The method according to any one of the preceding claims,
wherein a sampling pattern of the k-space data is varied between the multiple contrasts,
wherein the sampling pattern of at least some of the multiple contrasts is in particular an irregular sampling pattern.

7. The method according to any one of the preceding claims,
wherein a user is given the option via a user interface input to set a regularization strength of the regularization and/or to choose from multiple types of regularizations to be used for the added regularization;
wherein the input from the user is received and the regularization strength and/or the type of regularization is applied according to the user's input.

8. The method according to any one of the preceding claims,
wherein the conventional image reconstruction is further extended by a further regularization that is acting in a spatial domain.

9. The method according to any one of the preceding claims,
wherein applying the extended conventional image reconstruction comprises optimizing a cost function, the cost function comprising the regularization.

10. The method according to any one of the preceding claims,
wherein applying the extended conventional image reconstruction comprises applying an inner iteration loop,
wherein the inner iteration loop in particular comprises calculating a gradient of a term comprising the parallel imaging model and calculating or approximating a proximal operator of a function comprising the regularization.

11. The method according to any one of the preceding claims,
wherein, during iterative machine-learning-based k-space-to-image reconstruction, a CPU RAM is used as buffer and data for the reconstruction steps or parts of the reconstruction steps of the iteration are streamed to a GPU for processing, in particular by copying respective data from the CPU to the GPU for processing on the GPU and copying back results of the processing to the CPU for each reconstruction step or part of the reconstruction step.

12. A method for generating magnetic resonance image data, the method comprising the steps of
- acquiring multi-contrast k-space data via a magnetic resonance imaging system at multiple contrasts;
- performing a method according to any one of the preceding claims on the acquired multi-contrast k-space data.

13. A computer program or computer-readable storage medium, in particular non-transient storage medium, comprising instructions which, when executed by a computer, cause the computer to carry out the method of any one of the preceding claims.

14. A processing unit (2) that is configured to carry out the method according to any one of claims 1 to 12.

15. A magnetic resonance imaging system (1) that is configured to carry out the method according to any one of claims 1 to 12 and/or that comprises the processing unit (2) according to claim 14.
